# FASCICULE DE BREVET EUROPEEN

(11) **EP 3 725 099 B1**
(45) Date de publication et mention de la délivrance du brevet: **29.06.2022**
(21) Numéro de dépôt: 18815230.0
(22) Date de dépôt: 14.12.2018
(51) Int. Cl.: H04R 29/00, G01R 31/36

(54) **PROCEDE DE DETECTION D'UN DYSFONCTIONNEMENT D'UN CAPTEUR ACOUSTIQUE COUPLE A UN GENERATEUR ELECTROCHIMIQUE ET DISPOSITIF METTANT EN OEUVRE LEDIT PROCEDE**
VERFAHREN ZUR ERKENNUNG EINER FEHLFUNKTION EINES MIT EINEM ELEKTROCHEMISCHEN GENERATOR GEKOPPELTEN AKUSTISCHEN SENSORS UND VORRICHTUNG ZUR DURCHFÜHRUNG DES VERFAHRENS
METHOD FOR DETECTING A MALFUNCTION OF AN ACOUSTIC SENSOR COUPLED TO AN ELECTROCHEMICAL GENERATOR AND DEVICE IMPLEMENTING SAID METHOD

(30) Priorité: 14.12.2017 FR 1762110
(43) Date de publication de la demande: 21.10.2020
(73) Titulaire: Commissariat à l'Energie Atomique et aux Energies Alternatives, 75015 Paris (FR); Institut Polytechnique de Grenoble, 38031 Grenoble Cedex 01 (FR)
(72) Inventeur: GUILLET, Nicolas, 26300 Pizançon (FR); ALIAS, Mélanie, 77167 POLIGNY (FR); DEGRET, Florence, 92240 Malakoff (FR)
(74) Mandataire: Cabinet Camus Lebkiri
(86) Numéro de dépôt international: PCT/EP2018/084928
(87) Numéro de publication internationale: WO 2019/115757

(56) Documents cités:
- EP-A1- 2 575 205
- EP-B1- 2 575 205
- FR-A1- 3 011 336
- JP-A- 2010 071 945

## Description

### DOMAINE TECHNIQUE DE L'INVENTION

Le domaine technique de l'invention est celui de la détection des dysfonctionnements d'un capteur. La présente invention concerne la détection du dysfonctionnement d'un capteur acoustique et en particulier la détection du dysfonctionnement d'un capteur acoustique couplé à un générateur électrochimique.

### ARRIERE-PLAN TECHNOLOGIQUE DE L'INVENTION

Le suivi de l'état global d'une batterie, et plus généralement d'un générateur électrochimique, est devenu un enjeu majeur dans le domaine de la gestion d'énergie. Afin d'assurer un suivi continu de ces générateurs, même lorsque ces derniers sont en cours d'utilisation, différentes techniques ont été développées.

L'une d'entre-elles particulièrement prometteuse, consiste à émettre un signal acoustique au niveau d'une paroi d'un générateur puis à mesurer, par exemple à l'aide d'un capteur acoustique, la réponse du système. Il a été montré qu'une telle mesure permet d'accéder à des informations telles que l'état de santé ou l'état de charge du générateur. Cependant, une telle méthode nécessite un capteur acoustique fonctionnel.

Or, il est difficile de détecter le dysfonctionnement d'un capteur, que ce soit au moment de la calibration du dispositif de mesure ou bien tout au long de la vie de ce dernier. Des méthodes telles que le « cassé de mine de crayon » (méthode préconisée par l'organisme de normalisation ASTM International : ASTM E976 - 10 et E1106 - 12), bien que satisfaisante à l'échelle d'un laboratoire ne peuvent pas être utilisées pour vérifier le bon couplage d'un capteur avec un générateur électrochimique à l'échelle industrielle. En cours d'utilisation, aucune méthode satisfaisante n'existe pour l'instant. Certes, il est possible d'émettre un son avec un émetteur acoustique puis de mesurer la réponse du capteur acoustique. Mais cette technique ne permet pas de déterminer si le dysfonctionnement provient de l'émetteur acoustique ou du capteur acoustique.

Le document JP 2010 071945 A (TOYOTA MOTOR CORP), 2 avril 2010, décrit un appareil de mesure d'émission acoustique pour la détermination de la qualité d'une batterie aux ions de lithium pour un véhicule ; l'appareil détermine si un bruit externe est généré sur la base d'un signal d'émission acoustique externe détecté à l'extérieur de la batterie.

Il existe donc un besoin d'un procédé permettant de détecter le dysfonctionnement d'un capteur acoustique couplé à un générateur électrochimique non seulement lors de la calibration de ce dernier, mais également au cours de l'utilisation du générateur électrochimique. Il existe également un besoin d'un dispositif permettant de mettre en œuvre un tel procédé.

### RESUME DE L'INVENTION

L'invention offre une solution aux problèmes évoqués précédemment, en permettant de détecter un dysfonctionnement d'un capteur acoustique à partir d'un signal électrique appliqué sur les bornes d'un générateur électrochimique auquel le capteur acoustique est couplé.

Un premier aspect de l'invention concerne un procédé de détection d'un dysfonctionnement d'un capteur acoustique couplé à un générateur électrochimique GE selon la revendication 1.

Grâce à l'invention, il est possible de tester de manière fiable le bon fonctionnement d'un capteur acoustique couplé à un générateur électrochimique. Les inventeurs ont en effet découvert que, contre toute attente, l'application d'un signal électrique aux bornes d'un générateur électrochimique pouvait générer une onde acoustique dont la fréquence est proche de celle du signal électrique utilisé. Cette onde acoustique peut ensuite être utilisée pour vérifier le bon fonctionnement ou le dysfonctionnement d'un capteur acoustique.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles. Avantageusement, le capteur acoustique possède une fréquence de résonance et la fréquence signal est choisie en fonction de ladite fréquence de résonance. Ainsi, une plus grande sensibilité de détection est obtenue.

Avantageusement, la première étape d'application d'un signal électrique et la deuxième étape de mesure d'un signal acoustique sont répétées à une fréquence donnée, dite fréquence de détection. Ainsi, le procédé permet d'assurer un suivi du bon fonctionnement du capteur acoustique.

Selon l'invention, le signal électrique est superposé aux signaux électriques correspondant au fonctionnement normal du générateur électrochimique. Ainsi, le procédé peut être mis en œuvre alors que le générateur électrochimique est en cours d'utilisation.

Avantageusement, l'amplitude du signal acoustique considérée est la valeur moyenne de l'amplitude du signal acoustique mesurée sur une largeur de bande donnée. Ainsi, la fiabilité de la détection d'un dysfonctionnement est améliorée. Avantageusement, le signal électrique appliqué est de forme sinusoïdale, carrée ou triangulaire.

Avantageusement, le procédé selon un premier aspect de l'invention comprend, avant la première étape d'application d'un signal électrique, une étape d'étalonnage au cours de laquelle la valeur seuil et/ou l'amplitude signal sont déterminées. Ainsi, la valeur seuil et/ou l'amplitude signal sont adaptées aux particularités de chaque système.

Un deuxième aspect de l'invention concerne un dispositif selon la revendication 7 comprenant un moyen de calcul et un capteur acoustique destiné à être couplé audit générateur électrochimique, le dispositif étant configuré pour mettre en œuvre le procédé de détection selon un premier aspect de l'invention. Un tel dispositif permet d'assurer le suivi du bon fonctionnement d'un capteur acoustique.

Un troisième aspect de l'invention concerne un programme d'ordinateur selon la revendication 8 comprenant des instructions qui conduisent le dispositif selon un deuxième aspect de l'invention à exécuter les étapes du procédé selon un premier aspect de l'invention.

Un quatrième aspect de l'invention concerne un support lisible par ordinateur selon la revendication 9, sur lequel est enregistré le programme d'ordinateur selon un troisième aspect de l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1A montre un ordinogramme d'un procédé selon un premier aspect de l'invention.
- La figure 1B montre une représentation schématique d'un dispositif selon un deuxième aspect de l'invention.
- La figure 2 montre la réponse en fréquence d'un capteur piézoélectrique.
- La figure 3 montre une représentation schématique des signaux électriques dans un procédé selon un premier aspect de l'invention.
- La figure 4 montre une représentation schématique de l'évolution du signal acoustique mesurée dans un exemple de réalisation d'un procédé selon un premier aspect de l'invention.

### DESCRIPTION DETAILLEE D'AU MOINS UN MODE DE REALISATION DE L'INVENTION

Sauf précision contraire, un même élément apparaissant sur des figures différentes présente une référence unique.

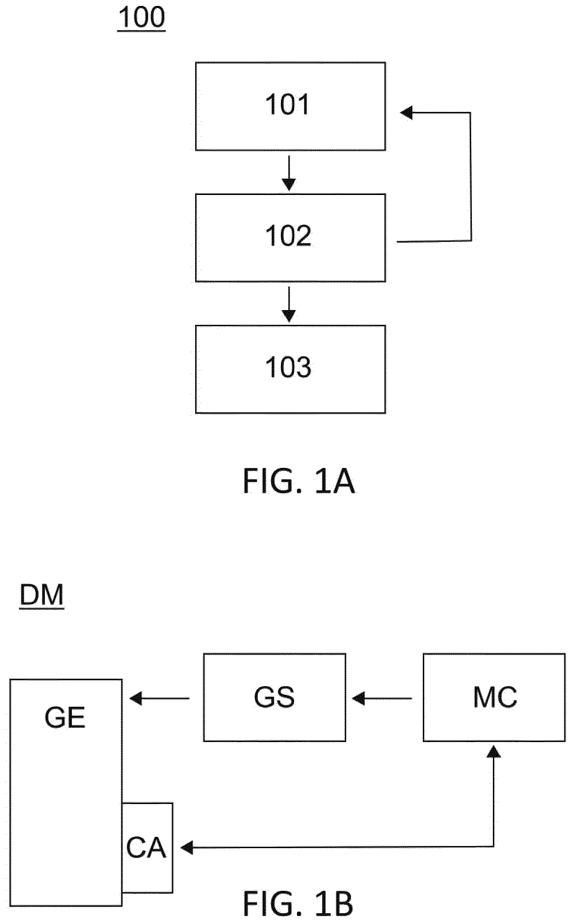

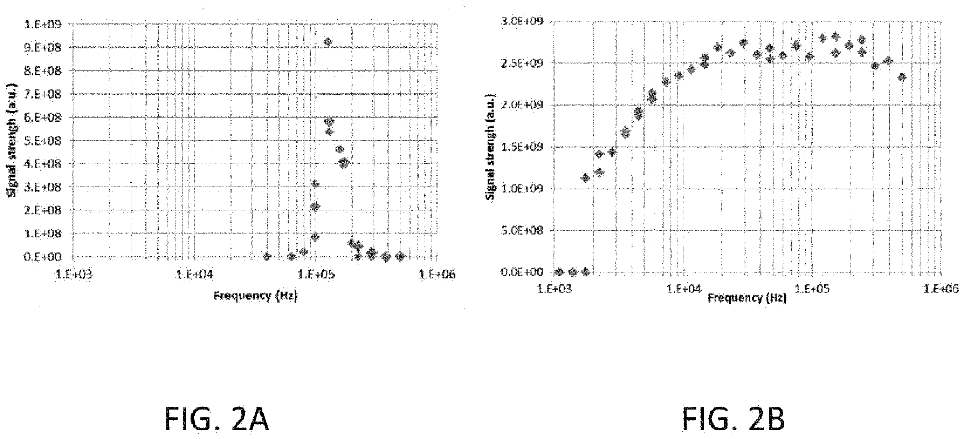

Un premier aspect de l'invention illustré en figure 1 concerne un procédé 100 de détection d'un dysfonctionnement d'un capteur acoustique CA couplé à un générateur électrochimique GE. Le capteur acoustique CA peut par exemple être un capteur piézoélectrique, notamment un capteur à base de céramiques ou de polymères piézoélectriques. Par exemple, le capteur acoustique CA peut comprendre un piézoélectrique en PZT (Titano-Zirconate de Plomb Pb(Zrₓ,Ti₁₋ₓ)O₃) qui permet d'obtenir un capteur ayant une résonance étroite (en général comprise entre 10kHz et quelques centaines de kHz) comme illustré à la figure 2A. Dans un autre exemple, le capteur acoustique peut comprendre un piézoélectrique en PVDF (Polymère Polyfluorure de Vinylidène) qui permet d'obtenir un capteur ayant une résonance large (en général comprise entre quelques kHz et quelques MHz) comme illustré à la figure 2B. Le couplage entre le capteur acoustique CA et le générateur électrochimique GE est par exemple obtenu par collage du capteur CA sur une paroi dudit générateur GE. Le générateur électrochimique GE peut notamment prendre la forme d'une batterie ou bien encore d'une pile à combustible. De manière plus générale, on entend par générateur électrochimique GE un dispositif permettant de convertir l'énergie chimique en énergie électrique. Le dysfonctionnement que le procédé 100 permet de détecter peut avoir plusieurs origines. Par exemple, le dysfonctionnement peut être dû à un problème au niveau du capteur CA lui-même ou bien être dû à un décollement total ou partiel du capteur CA entrainant une perte de couplage entre le capteur CA et le générateur électrochimique GE. Le dysfonctionnement peut également concerner une dérive dans les performances du capteur CA.

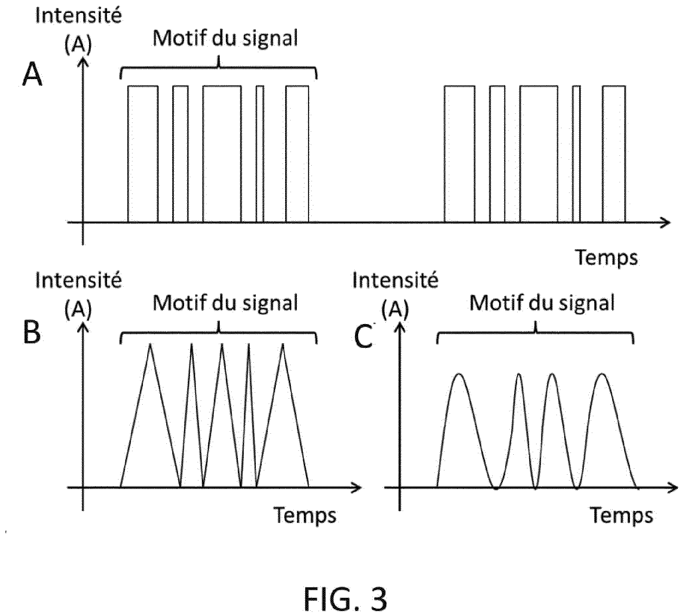

Le procédé 100 selon l'invention comprend une première étape 101 d'application d'un signal électrique SE à une fréquence donnée et une amplitude donnée, dites fréquence signal et amplitude signal, ladite fréquence signal étant de préférence comprise entre 1 kHz et 1 MHz. Le signal électrique SE peut consister en une variation de tension ou bien encore à une variation de courant. Le signal électrique SE peut être de forme quelconque ou, comme illustré à la figure 3, de forme carré (figure 3A), triangulaire (figure 3B) ou sinusoïdale (figure 3C). Le signal électrique SE peut être généré par une unité de gestion du générateur électrochimique GE ou bien encore par un générateur GS de signaux électriques SE connecté aux bornes du générateur électrochimique GE en plus (par exemple en parallèle) ou en lieu et place de l'unité de gestion du générateur électrochimique GE. Le signal électrique SE peut par exemple être superposé au courant de charge ou de décharge du générateur électrochimique GE. Les caractéristiques du signal électrique SE sont choisies en fonction de la nature du générateur électrochimique GE (taille, nature des matériaux, structure interne, etc.) et/ou du capteur acoustique CA. Ainsi, dans le cas d'un capteur PZT, la fréquence signal sera de préférence comprise entre 100 et 200 kHz, alors que dans le cas d'un capteur PVDF, la fréquence signal sera préférentiellement comprise entre 10 kHz et 200 kHz. L'amplitude du signal électrique SE doit être choisi de sorte à générer un signal acoustique SA qui peut être capté par le capteur acoustique CA. Cette amplitude va donc notamment dépendre du type de générateur électrochimique GE, de la sensibilité du capteur acoustique CA et de l'environnement de mesure (bruit parasite, etc.).

Dans un mode de réalisation, le capteur acoustique CA possède une fréquence de résonance et la fréquence signal SE est choisie en fonction de ladite fréquence de résonance. La fréquence de résonance peut être donnée par le fabricant du capteur CA ou mesurée une fois le capteur CA en place sur le générateur électrochimique GE. Dans un mode de réalisation, le signal électrique SE prend la forme d'impulsions à une fréquence donnée (par exemple, une fréquence comprise entre 1 KHz et 1 MHz) ou à une pluralité de fréquences. Les paramètres des impulsions (par exemple, temps séparant deux impulsions et/ou fréquence(s) du signal) peuvent ainsi constituer une signature propre à l'impulsion de sorte à pouvoir éventuellement faire la différence entre le signal acoustique SA généré par le signal électrique SE et les autres signaux acoustiques parasites. Ainsi, il est possible de ne prendre en compte que les signaux acoustiques SA présentant la même signature que les signaux électriques SE afin de détecter l'éventuel dysfonctionnement du capteur acoustique CA.

Le procédé 100 selon l'invention comprend également une deuxième étape 102 de mesure, par le capteur acoustique CA, du signal acoustique SA émis par le générateur électrochimique GE en réponse à l'application du signal électrique SE. En effet, les inventeurs ont mis en évidence que, contrairement à ce qui est attendu, l'application d'un signal électrique SE sur les bornes d'un générateur électrochimique GE entraine l'émission d'ondes acoustiques à une fréquence proche. Plus particulièrement, ces ondes acoustiques sont générées par les faibles contraintes mécaniques et leur relâchement qu'entraine l'application d'un signal électrique SE aux bornes du générateur électrochimique GE. Ainsi, l'application d'un signal électrique SE entraine, lorsqu'il n'y a pas de dysfonctionnement du capteur acoustique CA la mesure d'un signal acoustique SA par ledit capteur acoustique CA.

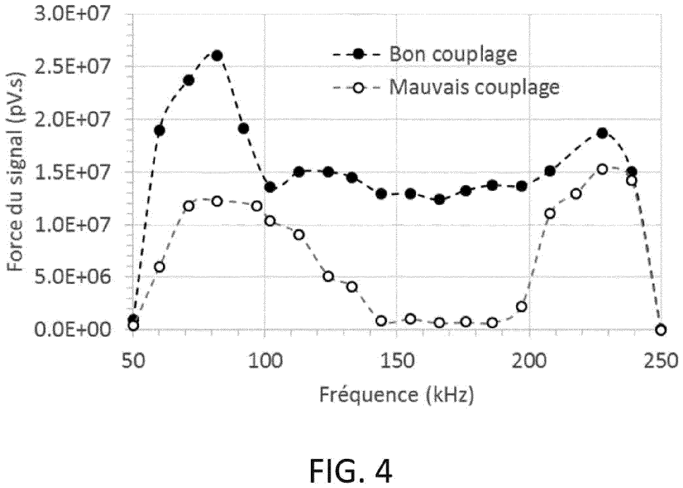

Le procédé 100 comprend également, lorsque l'amplitude du signal acoustique SA mesurée est en dessous d'une valeur seuil prédéterminée, une troisième étape 103 de détection d'un dysfonctionnement du capteur acoustique CA. Dans un mode de réalisation, l'amplitude du signal acoustique SA considérée est la valeur de l'amplitude mesurée à une fréquence de référence donnée. Dans un mode de réalisation, l'amplitude du signal acoustique SA considérée est la valeur mesurée à une fréquence particulière (par exemple à la fréquence pour laquelle l'amplitude du signal reçu est maximale) ou une valeur moyenne de l'amplitude acoustique mesurée sur une largeur de bande donnée (par exemple, sur toute ou partie de la gamme de fréquence balayée par le signal électrique SE). Un exemple d'une étape de détection de dysfonctionnement est illustré en figure 4, le dysfonctionnement consistant en un découplage du capteur acoustique CA, par exemple du fait d'un décollement partiel de ce dernier. La figure 4 représente la force du signal SA mesuré (la force du signal est définie comme l'intégrale de l'amplitude du signal mesuré pendant la durée du paquet de forme d'onde ; la force du signal est indépendante du gain et calculée sur toute la plage dynamique du signal reçu) en fonction de la fréquence du signal pour une situation dans laquelle le couplage entre le capteur acoustique CA et le générateur électrochimique GE est bon et pour une situation dans laquelle le couplage entre le capteur acoustique CA et le générateur électrochimique GE est mauvais. Comme cela apparait sur cette figure, lorsque le capteur acoustique est bien couplé au générateur électrochimique GE, le signal acoustique SA mesuré pour un signal électrique SE donné présente une évolution caractéristique de la force du signal en fonction de la fréquence. Cette courbe peut notamment être utilisée pour calibrer la détection. Lorsque le couplage entre le capteur acoustique CA et le générateur électrochimique GE se détériore, la distribution de la force du signal en fonction de la fréquence du signal mesuré par ledit capteur acoustique CA est modifiée et le dysfonctionnement peut être détecté. Dans l'exemple de la figure 4, on pourra prendre comme référence de l'amplitude mesurée la valeur moyenne de l'amplitude du signal mesuré entre 150 kHz et 200 kHz. On notera que la modification peut être progressive (le décollement se fait petit à petit) ou au contraire se produire soudainement.

Lorsqu'il est souhaitable d'effectuer un suivi de l'état du capteur acoustique CA, dans un mode de réalisation, la première étape 101 d'application d'un signal électrique SE et la deuxième étape 102 de mesure du signal acoustique SA sont répétée à une fréquence donnée, dite fréquence de détection. Ainsi, l'état du capteur acoustique CA est vérifié à la fréquence de détection.

Un deuxième aspect de l'invention illustré à la figure 1A concerne un dispositif DM comprenant un moyen de calcul MC, un capteur acoustique CA destiné à être couplé à un générateur électrochimique GE, ledit dispositif étant configuré pour mettre en œuvre le procédé 100 de détection selon un premier aspect de l'invention. Le capteur acoustique CA peut par exemple être un capteur piézoélectrique, notamment un capteur à base de céramiques ou de polymères piézoélectriques. Par exemple, le capteur acoustique CA peut comprendre un piézoélectrique en PZT (Titano-Zirconate de Plomb) qui permet d'obtenir un capteur ayant une résonance étroite (en général comprise entre 10 kHz et quelques centaines de kHz) comme illustrée à la figure 2A. Dans un autre exemple, le capteur acoustique peut comprendre un piézoélectrique en PVDF (Polymère Polyfluorure de Vinylidène) qui permet d'obtenir un capteur ayant une fréquence de résonance large (en général comprise entre quelque kHz et quelques MHz) comme illustré à la figure 2B. Le couplage entre ledit capteur CA et le générateur électrochimique GE est par exemple obtenu par collage du capteur sur une paroi dudit générateur GE. Le générateur électrochimique GE peut notamment prendre la forme d'une batterie ou bien encore d'une pile à combustible. De manière plus générale, on entend par générateur électrochimique GE un dispositif permettant de convertir l'énergie chimique en énergie électrique. Dans un mode de réalisation, le générateur électrochimique comprend une unité de gestion et le moyen de calcul MC comprend des moyens pour se connecter à ladite unité de gestion de sorte à appliquer un signal électrique SE au générateur électrochimique GE. Dans un mode de réalisation, le dispositif DM comprend un générateur de signaux électrique GS, par exemple générateur de signaux arbitraires ou un potentiostat, de sorte à pouvoir appliquer un signal électrique SE aux bornes du générateur électrochimique GE. Le dysfonctionnement que le dispositif DM permet de détecter peut avoir plusieurs origines. Par exemple, le dysfonctionnement peut être dû à un problème au niveau du capteur CA lui-même ou bien être dû à un décollement total ou partiel du capteur CA entrainant une perte de couplage entre le capteur CA et le générateur électrochimique GE. Le dysfonctionnement peut également concerner une dérive dans les performances du capteur acoustique CA. Le moyen de calcul MC peut prendre la forme d'un processeur associé à une mémoire, d'un FPGA ou bien encore d'une carte ASIC. Le moyen de calcul MC peut également comprendre une mémoire pour stocker les instructions qui permettent au dispositif DM de mettre en oeuvre le procédé 100 selon un premier aspect de l'invention. Le moyen de calcul MC comprend des moyens pour recevoir les signaux captés par le capteur acoustique. Dans un mode de réalisation, il comprend également des moyens pour traiter les signaux acoustiques SA reçus du capteur acoustique CA (par exemple, filtrer ou bien encore calculer une valeur moyenne d'une grandeur du signal, comme l'amplitude). Il comprend également des moyens pour envoyer des instructions de sorte à commander l'unité de gestion du générateur électrochimique ou le générateur de signaux. Ainsi, les signaux électriques peuvent être générés sur commande du moyen de calcul. Dans un mode de réalisation, le dispositif comprend des moyens de saisie, par exemple un clavier, de sorte que l'utilisateur puisse choisir un ou plusieurs paramètres du procédé 100, comme l'intervalle de temps séparant deux vérifications du bon fonctionnement du capteur acoustique CA. Le dispositif DM peut également comprendre un moyen d'affichage, par exemple un écran, pour afficher un dysfonctionnement lorsque ce dernier est détecté. Avantageusement, le dispositif DM comprend un écran tactile permettant la saisie et l'affichage.

## Revendications

1. Procédé (100) de détection d'un dysfonctionnement d'un capteur acoustique (CA) couplé à un générateur électrochimique (GE) comprenant :
- une première étape (101) d'application d'un signal électrique (SE) à une fréquence donnée et une amplitude donnée, dites fréquence signal et amplitude signal, le signal électrique étant superposé aux signaux électriques correspondant au fonctionnement normal du générateur électrochimique ;
- une deuxième étape (102) de mesure, par le capteur acoustique (CA), d'un signal acoustique (SA) émis par le générateur électrochimique (GE) en réponse à l'application du signal électrique (SE) ;
- lorsque l'amplitude du signal acoustique (SA) est en dessous d'une valeur seuil prédéterminée, une troisième étape (103) de détection d'un dysfonctionnement du capteur acoustique (CA).

2. Procédé (100) selon la revendication précédente **caractérisé en ce que** le capteur acoustique (CA) possède une fréquence de résonance et **en ce que** la fréquence signal (SE) est choisie en fonction de ladite fréquence de résonance.

3. Procédé (100) selon l'une des revendications précédentes **caractérisé en ce que** la première étape (101) d'application d'un signal électrique (SE) et la deuxième étape (102) de mesure d'un signal acoustique (SA) sont répétées à une fréquence donnée, dite fréquence de détection.

4. Procédé (100) selon l'une des revendications précédentes **caractérisé en ce que** l'amplitude du signal acoustique (SA) considérée est la valeur moyenne de l'amplitude du signal acoustique (SA) mesurée sur une largeur de bande donnée.

5. Procédé (100) selon l'une des revendications précédentes **caractérisé en ce que** le signal électrique (SE) appliqué est de forme sinusoïdale, carrée ou triangulaire.

6. Procédé (100) selon l'une des revendications précédentes **caractérisé en ce qu'**il comprend, avant la première étape (101) d'application d'un signal électrique (SE), une étape (ET) d'étalonnage au cours de laquelle la valeur seuil et l'amplitude signal sont déterminées.

7. Dispositif (DM) comprenant un moyen de calcul (MC) et un capteur acoustique (CA) destiné à être couplé à un générateur électrochimique (GE) **caractérisé en ce qu'**il est configuré pour mettre en œuvre le procédé (100) de détection selon l'une des revendications précédentes.

8. Programme d'ordinateur comprenant des instructions qui conduisent le dispositif (DM) selon la revendication précédente à exécuter les étapes du procédé (100) selon l'une des revendications 1 à 6.

9. Support lisible par ordinateur, sur lequel est enregistré le programme d'ordinateur selon la revendication 8.

## Patentansprüche

1. Detektionsverfahren (100) einer Fehlfunktion eines akustischen Sensors (CA), der an einen elektrochemischen Generator (GE) gekoppelt ist, umfassend:
- einen ersten Anwendungsschritt (101) eines elektrischen Signals (SE) auf eine bestimmte Frequenz und eine bestimmte Amplitude, bezeichnet als Signalfrequenz und Signalamplitude, wobei das elektrische Signal den elektrischen Signalen überlagert ist, die dem Normalbetrieb des elektrochemischen Generators entsprechen;
- einen zweiten Messschritt (102) eines akustischen Signals (SA), das vom elektrochemischen Generator (GE) als Antwort auf die Anwendung des elektrischen Signals (SE) ausgegeben wird, durch den akustischen Sensor (CA);
- wenn die Amplitude des akustischen Signals (SA) unter einem vorbestimmten Grenzwert liegt, einen dritten Detektionsschritt (130) einer Fehlfunktion des akustischen Sensors (CA).

2. Verfahren (100) gemäß dem voranstehenden Anspruch, **dadurch gekennzeichnet, dass** der akustische Sensor (CA) eine Resonanzfrequenz besitzt und dass die Signalfrequenz (SE) in Abhängigkeit von der genannten Resonanzfrequenz ausgewählt ist.

3. Verfahren (100) gemäß einem der voranstehenden Ansprüche, **dadurch gekennzeichnet, dass** der erste Anwendungsschritt (101) eines elektrischen Signals (SE) und der zweite Messschritt (102) eines akustischen Signals (SA) in einer bestimmten Frequenz, bezeichnet als Detektionsfrequenz, wiederholt werden.

4. Verfahren (100) gemäß einem der voranstehenden Ansprüche, **dadurch gekennzeichnet, dass** die Amplitude des betrachteten akustischen Signals (SA) der durchschnittliche Wert der Amplitude des akustischen Signals (SA) ist, das auf eine bestimmte Bandbreite gemessen wird.

5. Verfahren (100) gemäß einem der voranstehenden Ansprüche, **dadurch gekennzeichnet, dass** das angewendete elektrische Signal (SE) eine sinusförmige, quadratische oder dreieckige Form aufweist.

6. Verfahren (100) gemäß einem der voranstehenden Ansprüche, **dadurch gekennzeichnet, dass** es vor dem ersten Anwendungsschritt (101) eines elektrischen Signals (SE) einen Kalibrierungsschritt (ET) umfasst, in dessen Verlauf der Grenzwert und die Signalamplitude bestimmt werden.

7. Vorrichtung (DM), umfassend ein Berechnungsmittel (MC) und einen akustischen Sensor (CA), der dazu bestimmt ist, an einem elektrochemischen Generator (GE) gekoppelt zu sein, **dadurch gekennzeichnet, dass** sie ausgestaltet ist, um das Detektionsverfahren (100) gemäß einem der voranstehenden Ansprüche umzusetzen.

8. Computerprogramm, umfassend Anweisungen, die die Vorrichtung (DM) gemäß dem voranstehenden Anspruch zum Ausführen der Schritte des Verfahrens (100) gemäß einem der Ansprüche 1 bis 6 veranlassen.

9. Per Computer lesbarer Träger, auf dem das Computerprogramm gemäß Anspruch 8 gespeichert ist.

## Claims

1. Method (100) for detecting a malfunction of an acoustic sensor (CA) coupled to an electrochemical generator (GE) comprising:
- a first step (101) of applying an electrical signal (SE) at a given frequency and a given amplitude, termed the signal frequency and signal amplitude the electrical signal (SE) is superimposed on the electrical signals corresponding to the normal operation of the electrochemical generator (GE);
- a second step (102) of measuring, by the acoustic sensor (CA), an acoustic signal (SA) emitted by the electrochemical generator (GE) in response to the application of the electrical signal (SE);
- when the amplitude of the acoustic signal (SA) is below a predetermined threshold value, a third step (103) of detecting a malfunction of the acoustic sensor (CA).

2. Method (100) according to the preceding claim **characterised in that** the acoustic sensor (CA) has a resonance frequency and **in that** the signal frequency (SE) is chosen according to said resonance frequency.

3. Method (100) according to one of the preceding claims **characterised in that** the first step (101) of applying an electrical signal (SE) and the second step (102) of measuring an acoustic signal (SA) are repeated at a given frequency, termed the detection frequency.

4. Method (100) according to one of the preceding claims **characterised in that** the amplitude of the acoustic signal (SA) considered is the average value of the amplitude of the acoustic signal (SA) measured over a given bandwidth.

5. Method (100) according to one of the preceding claims **characterised in that** the electrical signal (SE) applied has sine, square, triangular shape.

6. Method (100) according to one of the preceding claims **characterised in that** it comprises, before the first step (101) of applying an electrical signal (SE), a step (AND) of calibrating during which the threshold value and the signal amplitude are determined.

7. Device (DM) comprising a means of calculating (MC) and an acoustic sensor (CA) intended to be coupled to an electrochemical generator (GE) **characterised in that** it is configured to implement the method (100) for detecting according to one of the preceding claims.

8. Computer program comprising instructions which lead the device (DM) according to the preceding claim to execute the steps of the method (100) according to one of claims 1 to 6.

9. Support that can be read by a computer, on which the computer program is recorded according to claim 8.
